# EUROPEAN PATENT SPECIFICATION

(11) **EP 4 451 503 B1**
(45) Date of publication and mention of the grant of the patent: **02.09.2026**
(21) Application number: 23865690.4
(22) Date of filing: 12.07.2023
(51) Int. Cl.: H01M 10/44, H01M 10/48, H02J 7/00, G01R 31/382, G01R 31/385, G01R 31/396, G01R 31/389, B60L 58/12, B60L 3/00, G01R 31/36

(54) **BATTERY MANAGEMENT SYSTEM, BATTERY PACK, ELECTRIC VEHICLE, AND BATTERY CHARGING TIME PREDICTION METHOD**
BATTERIEVERWALTUNGSSYSTEM, BATTERIEPACK, ELEKTROFAHRZEUG UND BATTERIELADEZEITVORHERSAGEVERFAHREN
SYSTÈME DE GESTION DE BATTERIE, BLOC-BATTERIE, VÉHICULE ÉLECTRIQUE ET PROCÉDÉ DE PRÉDICTION DE TEMPS DE CHARGE DE BATTERIE

(30) Priority: 15.09.2022 KR 20220116579; 25.04.2023 KR 20230054311
(43) Date of publication of application: 23.10.2024
(73) Proprietor: LG Energy Solution, Ltd., Seoul 07335 (KR)
(72) Inventor: KIM, Jae-Gu, Daejeon 34122 (KR)
(74) Representative: Plasseraud IP
(86) International application number: PCT/KR2023/009977
(87) International publication number: WO 2024/058387

(56) References cited:
- EP-A1- 3 829 024
- EP-B1- 3 764 114
- CN-A- 110 909 443
- JP-A- 2009 300 209
- JP-A- 2020 036 393
- KR-A- 20180 056 238
- KR-A- 20190 046 410
- KR-A- 20210 029 878
- US-A1- 2021 063 491

## Description

### TECHNICAL FIELD

The present disclosure relates to a technology for estimating a remaining charging time of a battery.

The present application claims priority to Korean Patent Application No. 10-2022-0116579 filed on September 15, 2022 in the Republic of Korea and Korean Patent Application No. 10-2023-0054311 filed on April 25, 2023 in the Republic of Korea.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

When charging a battery, if the charge rate (C-rate) of the charging current is low, a very long time is required to fully charge the battery. On the other hand, if the charge rate of the charging current is too high, it causes the side effect that the battery deteriorates quickly. Therefore, during constant-current charging, it is necessary to gradually adjust the charge rate of the charging current according to the state of the battery. For reference, the charge rate (may also be referred to as 'C-rate') is the value obtained by dividing the charging current by the maximum capacity of the battery, and 'C' is used as the unit.

To adjust the charge rate in stages during constant-current charging, a charge rate map with the so-called 'multi-stage constant-current charging protocol' is mainly used. A separate charge rate map can be created for each of a plurality of temperature sections, and a specific charge rate map is a table or function in which the relationship between the plurality of charge rates and the plurality of transition conditions associated with the specific temperature section is recorded. If the state of the battery satisfies a specific transition condition (e.g., SOC reaches 60%) while charging using any one of the plurality of charge rates recorded in the specific charge rate map, the next charge rate may be supplied to the battery as the charging current.

Relatedly, during battery charging, it is necessary to notify the user of how much time remains until the SOC of the battery reaches a target SOC (e.g., fully charged state).

Conventionally, when changing the charge rate step by step during charging using a multi-stage constant-current charging protocol, there is no way to reflect the change in battery temperature, so the remaining charging time is predicted on the assumption that the battery temperature at the charging start point is maintained.

However, it is common knowledge that battery temperature generally increases during charging, and therefore, there is a problem that the remaining charging time predicted according to the conventional method described above shows a large discrepancy from the charging time actually consumed.

Example of background art is disclosed in EP 3 764 114 B1, CN 110 909 443 A, JP 2020 036393 A, EP 3 829 024 A1 and KR 2021 0029878 A.

### DISCLOSURE

### Technical Problem

The present disclosure is designed to solve the problems of the related art, and therefore the present disclosure is directed to providing a battery management system that can improve the prediction accuracy of the remaining charging time until the SOC of the battery reaches the target SOC by repeating the process of predicting the change in battery temperature at each stage (SOC range) during charging using a multi-stage constant-current charging protocol to estimate the charge rate to be used in the next stage, and predicting a predicted charging time value at each stage according to the estimated charge rate; a battery pack including the battery management system; an electric vehicle including the battery pack; and a battery charging time prediction method that can be implemented in the battery management system.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management system according to an aspect of the present disclosure is defined in the appended claims.

A battery pack according to another aspect of the present disclosure is also provided.

An electric vehicle according to still another aspect of the present disclosure is also provided.

A battery charging time prediction method according to still another aspect of the present disclosure is provided.

### Advantageous Effects

According to at least one of the embodiments of the present disclosure, during charging using the multi-stage constant-current charging protocol, it is possible to improve the prediction accuracy of the remaining charging time until the SOC of the battery reaches the target SOC by repeating the process of predicting the change in battery temperature at each stage (SOC range) to estimate the charge rate to be used in the next stage, and predicting a predicted charging time value at each stage according to the estimated charge rate.

In addition, according to at least one of the embodiments of the present disclosure, the prediction accuracy of the remaining charging time can be further improved by predicting the change in battery temperature at each stage by additionally utilizing not only the battery temperature but also the external temperature.

In addition, according to at least one of the embodiments of the present disclosure, by adjusting the end point of each stage according to the difference between the predicted temperature change amount value and the actual temperature change amount for the corresponding stage, the prediction accuracy of the remaining charging time in the charging procedure to be resumed in the future can be improved.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a drawing illustrating the configuration of an electric vehicle according to the present disclosure.
FIG. 2 is a diagram referenced to explain an exemplary first charge reference map used in a charging procedure using a multi-stage constant-current charging protocol.
FIG. 3 is a schematic diagram referenced to explain an example of the process of estimating the total remaining time, executed by the battery management system shown in FIG. 1.
FIG. 4 is a diagram referenced to explain an exemplary second charge reference map used in a charging procedure using a multi-stage constant-current charging protocol.
FIG. 5 is a schematic diagram referenced to explain another example of the process of estimating the total remaining time, executed by the battery management system shown in FIG. 1.
FIG. 6 is a flowchart exemplarily illustrating a battery charging time prediction method according to the first embodiment of the present disclosure.
FIG. 7 is a flowchart exemplarily illustrating a battery charging time prediction method according to the second embodiment of the present disclosure.
FIG. 8 is a flowchart exemplarily illustrating a battery charging time prediction method according to the third embodiment of the present disclosure.
FIG. 9 is a flowchart exemplarily illustrating a battery charging time prediction method according to the fourth embodiment of the present disclosure.
FIG. 10 is a flowchart exemplarily illustrating a battery charging time prediction method according to the fifth embodiment of the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise. Additionally, terms such as "... unit" described in the specification refer to a unit that processes at least one function or operation, and may be implemented as hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

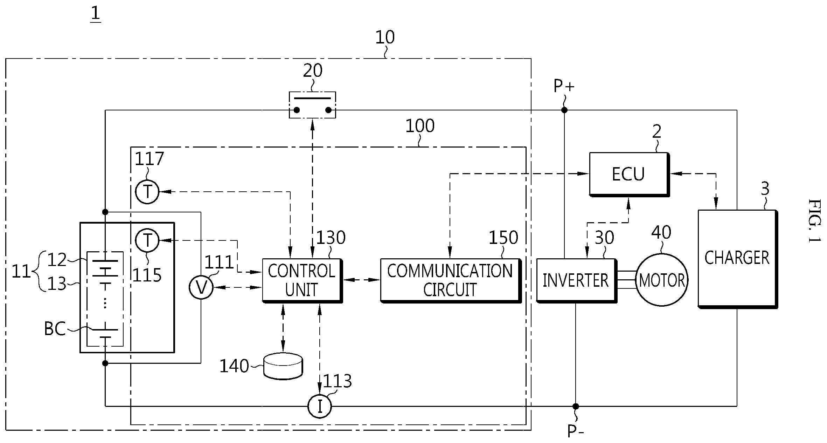

FIG. 1 is a drawing illustrating the configuration of an electric vehicle according to the present disclosure.

Referring to FIG. 1, the electric vehicle 1 includes a vehicle controller 2, a battery pack 10, a relay 20, an inverter 30, and an electric motor 40. The charging and discharging terminals P+, P- of the battery pack 10 can be electrically connected to the charger 3 through a charging cable, etc. The charger 3 may be included in the electric vehicle 1 or may be provided at the charging station.

The vehicle controller 2 (e.g., ECU: Electronic Control Unit) is configured to transmit a key-on signal to the battery management system 100 in response to the start button (not shown) provided in the electric vehicle 1 being switched to the ON position by the user. The vehicle controller 2 is configured to transmit a key-off signal to the battery management system 100 in response to the start button being switched to the OFF position by the user. The charger 3 can communicate with the vehicle controller 2 and supply constant-current or constant-voltage charging power through the charging and discharging terminals P+, P- of the battery pack 10.

The battery pack 10 includes a battery 11 and a battery management system 100.

The battery 11 includes a cell group 12 and a case 13. The case 13 defines the overall appearance of the battery 11 and provides an inner space where the cell group 12 can be placed. The case 13 is fixed to the battery room provided in the electric vehicle 1 using bolts, etc.

The cell group 12 is disposed (stored) in the inner space provided from the case 13 and includes at least one battery cell BC. The type of battery cell BC is not particularly limited as long as it can be repeatedly charged and discharged, for example, a lithium-ion cell.

When the cell group 12 includes a plurality of battery cells, these plurality of battery cells may be connected in series, in parallel, or in a mixture of series and parallel.

The relay 20 is electrically connected in series to the battery 11 through a power path that connects the battery 11 and the inverter 30. In FIG. 1, the relay 20 is illustrated as connected between the positive terminal of the battery 11 and the charging and discharging terminals P+. The relay 20 is controlled to turn on and off in response to a switching signal from the battery management system 100. The relay 20 may be a mechanical contactor turned on and off by the magnetic force of the coil, or a semiconductor switch such as a MOSFET (Metal Oxide Semiconductor Field Effect transistor).

The inverter 30 is provided to convert DC current from the cell group 12 into AC current in response to commands from the battery management system 100 or the vehicle controller 2.

The electric motor 40 is driven using AC power from the inverter 30. As the electric motor 40, for example, a 3-phase AC motor 40 can be used.

The battery management system 100 includes a voltage sensor 111, a current sensor 113, a battery temperature sensor 115, and a control unit 130. The battery management system 100 further includes an outdoor air temperature sensor 117. The battery management system 100 may further include a communication circuit 150.

The voltage sensor 111 is connected in parallel to the battery 11, and is configured to detect the battery voltage, which is the voltage across both ends of the battery 11, and generate a voltage signal representing the detected battery voltage.

The current sensor 113 is connected in series to the battery 11 through the current path between the battery 11 and the inverter 30. The current sensor 113 is configured to detect battery current, which is the current flowing through the battery 11, and generate a current signal representing the detected battery current. The current sensor 113 may be implemented with one of known current detection elements such as a shunt resistor and a Hall effect element, or a combination of two or more of them.

The battery temperature sensor 115 is configured to detect battery temperature and generate a temperature signal representing the detected battery temperature. The battery temperature sensor 115 may be placed in the case 13 to detect a temperature close to the actual temperature of the battery 11. For example, the battery temperature sensor 115 may be attached to the surface of at least one battery cell BC included in the cell group 12, and may detect the surface temperature of the battery cell BC as the battery temperature.

The voltage sensor 111, the current sensor 113, and the battery temperature sensor 115 may be referred to as a 'sensing unit'.

The outdoor air temperature sensor 117 is configured to detect outdoor air temperature (atmosphere temperature), which is the temperature at a predetermined location spaced apart from the battery 11, and generate a temperature signal representing the detected outdoor air temperature. The outdoor air temperature sensor 117 may be placed at a predetermined location outside the case 13 where heat exchange occurs between the battery 11 and the outdoor air.

Each of the battery temperature sensor 115 and the outdoor air temperature sensor 117 may be implemented with one of known temperature detection elements such as thermocouples, thermistors, and bimetals, or a combination of two or more of them.

The communication circuit 150 is configured to support wired or wireless communication between the control unit 130 and the vehicle controller 2. Wired communication may be, for example, CAN (Controller Area Network) communication, and wireless communication may be, for example, ZigBee or Bluetooth communication. Of course, the type of communication protocol is not particularly limited as long as it supports wired and wireless communication between the control unit 130 and the vehicle controller 2. The communication circuit 150 may include an output device (e.g., display, speaker) that provides information received from the control unit 130 and/or the vehicle controller 2 in a form recognizable to the user.

The control unit 130 is operably coupled to the relay 20, the voltage sensor 111, the current sensor 113, the battery temperature sensor 115, the outdoor air temperature sensor 117, and the communication circuit 150. The operational combination of two components means that the two components are connected directly or indirectly to enable transmission and reception of signals in one direction or both directions.

The control unit 130 may collect a voltage signal from the voltage sensor 111, a current signal from the current sensor 113, a temperature signal from the battery temperature sensor 115 (can be referred to as a 'battery temperature signal'), and/or a temperature signal from the outdoor air temperature sensor 117 (can be referred to as an 'outdoor air temperature signal'). The control unit 130 may convert and record each analog signal collected from the sensors 111, 113, 115, 117 into digital values using an ADC (Analog to Digital Converter) provided therein.

The control unit 130 may be referred to as a 'control circuit' or a 'battery controller', and in terms of hardware, it may be implemented using at least one of ASICs (application specific integrated circuits), DSPs (digital signal processors), DSPDs (digital signal processing devices), PLDs (programmable logic devices), FPGAs (field programmable gate arrays), microprocessors, and other electrical units to perform functions.

The memory 140 may include at least one type of storage medium selected from, for example, flash memory type, hard disk type, SSD (Solid State Disk) type, SDD (Silicon Disk Drive) type, multimedia card micro type, RAM (random access memory), SRAM (static random access memory), ROM (read-only memory), EEPROM (electrically erasable programmable read-only memory), or PROM (programmable read-only memory). The memory 140 can store data and programs required for calculation operations by the control unit 130. The memory 140 can store data representing the results of an operation performed by the control unit 130. In FIG. 1, the memory 140 is shown as being physically independent from the control unit 130, but it may also be built in the control unit 130.

The memory 140 may store at least one charge reference map associated with the multi-stage constant-current charging protocol for the battery 11. Each charge reference map will be described in more detail below.

The control unit 130 may turn on the relay 20 in response to the key-on signal. The control unit 130 may turn off the relay 20 in response to the key-off signal. The key-off signal indicates a transition from a use state to an idle state. Alternatively, the vehicle controller 2 may be responsible for on-off control of the relay 20 instead of the control unit 130.

While the relay 20 is turned on, the battery 11 is in use. Conversely, while the relay 20 is turned off, the battery 11 is in an idle state. The use state is a state in which the battery 11 is being charged and discharged, and can also be referred to as a 'cycle state'. The idle state is a state in which charging and discharging of the battery 11 is stopped, and can also be called a 'calendar state'.

While the battery 11 is in use, the control unit 130 may determine a voltage detection value, a current detection value, a battery temperature detection value, and an outdoor air temperature detection value based on the voltage signal, the current signal, the battery temperature signal, and the outdoor air temperature signal, and then determine (estimate) the state of charge (SOC) of the battery 11 based on the voltage detection value, the current detection value, and/or the battery temperature detection value. SOC is the ratio of the remaining capacity to the fully charged capacity (maximum capacity) of the battery 11, and is usually processed in the range of 0 to 1 or 0% to 100%. To determine SOC, known methods such as ampere counting, OCV (Open Circuit Voltage)-SOC curve, and/or Kalman filter can be used. For reference, in this specification, simple description 'temperature detection value' may refer to a battery temperature detection value.

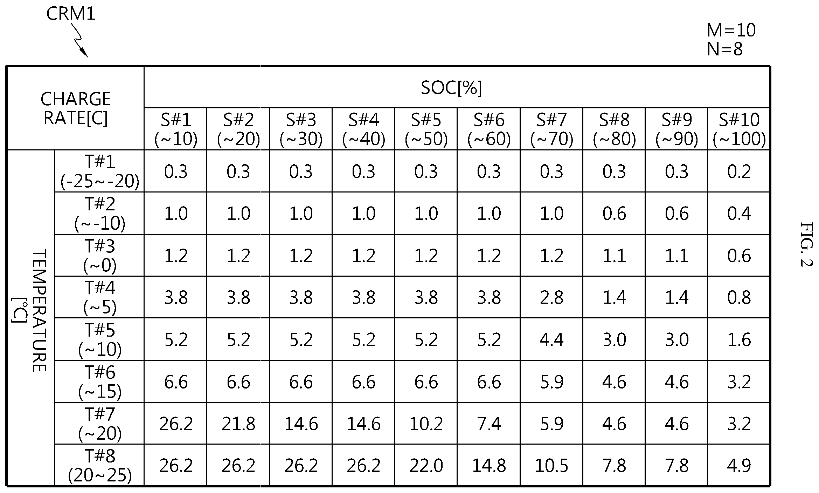

FIG. 2 is a diagram referenced to explain an exemplary first charge reference map used in a charging procedure using a multi-stage constant-current charging protocol.

Referring to FIG. 2, the first charge reference map CRM1 is a table or function representing the correspondence between the charge rate for SOC and temperature of the battery 11, and can be referred to as a 'charge rate map'.

Specifically, in the first charge reference map CRM1, a total of M × N charge rates for the first to M^{th} SOC sections (S#1 to S#M) and the first to N^{th} temperature sections (T#1 to T#N) associated with the multi-stage constant-current charging protocol are recorded. Here, M and N are natural numbers of 2 or more, respectively.

When m is a natural number less than or equal to M and n is a natural number less than or equal to N, the symbol C#m_n used in this specification represents the charge rate associated with the SOC section (S#m) and the temperature section (T#n). Additionally, the size (width) of the SOC section (S#m) is the difference between the start point and the end point of the SOC section (S#m). For example, in FIG. 2, the start point of the SOC section (S#3) is 20%, the end point is 30%, and the size is 10%. The symbol ΔS#m used in this specification represents the size of the SOC section (S#m).

The first to M^{th} SOC section (S#1 to S#M) may be divided from the entire SOC range predetermined as the target of a charging procedure using a multi-stage constant-current charging protocol. That is, the start point of the first SOC section is the same as the start point of the entire SOC range, and the end point of the M^{th} SOC section (S#M) is the same as the end point of the entire SOC range associated with the multi-stage constant-current charging protocol. The end point of the entire SOC range can be preset as the target SOC. Additionally, in the first to M^{th} SOC sections (S#1 to S#M), the end point of the preceding section among the two adjacent sections may coincide with the start point of the following section. For example, the end point of the first SOC section coincides with the start point of the second SOC section.

In FIG. 2, there is illustrated that the full SOC range = 0 to 100%, M = 10, N = 8. That is, a total of 80 charge rates for the first to the 10^{th} SOC sections (S#1 to S#10) and the first to the 8^{th} temperature sections (T#1 to T#8) are recorded in the first charge reference map CRM1. Meanwhile, in FIG. 2, the size of each SOC section (S#1 to S#10) is shown to be the same as 10%, but this should be understood as an example. That is, at least two of the SOC sections (S#1 to S#10) may be preset to have different sizes.

It is assumed that i and j, which are natural numbers less than or equal to M, satisfy i < j, and x and y, which are natural numbers less than or equal to N, satisfy x < y. Looking at the first charge reference map CRM1 shown in FIG. 2, in a specific temperature section, the charge rate associated with the SOC section (S#j) may be less than or equal to the charge rate associated with the SOC section (S#i). As an example, in the temperature section (T#1), the charge rate (C#_{10_1}) 0.2 C associated with the SOC section (S#10) is smaller than the charge rate (C#_{9_1}) 0.3 C associated with the SOC section (S#9).

Additionally, in a specific SOC section, the charge rate associated with the temperature section (T#y) may be greater than or equal to the charge rate associated with the SOC section (T#x). As an example, in the SOC section (S#5), the charge rate (C#_{5_3}) 1.2 C associated with the temperature section (T#3) is greater than the charge rate (C#_{5_2}) 1.0 C associated with the temperature section (T#2).

In relation to this, the above-described example assumes that the first to eighth temperature sections (T#1 to T#8) are partitioned from a predetermined appropriate temperature range. Therefore, at temperatures lower than the start point of the temperature section (T#1) or higher than the end point of the temperature section (T#8), it should be understood that the change in charge rate according to temperature and SOC may be determined differently from FIG. 2.

Previously, there was no way to reflect battery temperature during charging in charge rate transition. For this reason, in predicting the remaining charging time until the target SOC is reached, the battery temperature (detection value or predicted value) at the current point is set to remain the same until the target SOC is reached. Thus, situations where the predicted value of the remaining charging time until reaching the target SOC was significantly different from reality frequently occurred.

For example, if the SOC estimation value of the battery 11 belongs to the SOC section (S#1) and the temperature detection value belongs to the temperature section (T#2) at the current time, constant-current charging using the charge rate (C#_{1_2}) of 1.0 C is performed. However, although the temperature of the battery 11 at the end point of the SOC section (S#1) may actually belong to the temperature section (T#3) due to constant-current charging in the SOC section (S#1), the conventional method assumes that the temperature of the battery 11 remains in the temperature section (T#2) even in the SOC section (S#2) when predicting the remaining charging time. In this case, 1.0 C, which is the charge rate (C#_{2_2}) associated with the temperature section (T#2) and the SOC section (S#2), and 1.2 C, which is the charge rate (C#_{3_3}) associated with the temperature section (T#3) and the SOC section (S#2) have a difference of 0.2 C, and a difference between the time predicted to be required for charging from the start point to the end point of the SOC section (S#2) and the time actually required is generated as much as this difference. In addition, it is obvious that there may be a time difference between the predicted value and the actual value in each of the remaining SOC sections (S#3 to S#10) following the SOC section (S#2), and as the time differences in the SOC sections (S#2 to S#10) accumulate, the time difference between the predicted value and the actual value for the total remaining time until reaching the target SOC may become larger.

The present disclosure predicts the battery temperature in the next SOC section (e.g., S#2) during constant-current charging in a specific SOC section (e.g., S#1), reflects the predicted battery temperature in a subsequent SOC section (e.g., S#2) to predict which charge rate will be selected among the N charge rates, and then predicts the predicted charging time value in the SOC section (e.g. S#2) based on the predicted charge rate. Accordingly, compared to the conventional method described above, there is a technical effect in that the predicted charging time value for each SOC section from the current SOC section to the last SOC section can be obtained close to the actual value.

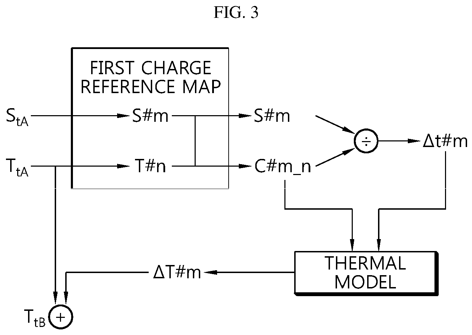

FIG. 3 is a schematic diagram referenced to explain an example of the process of estimating the total remaining time, executed by the battery management system 100 shown in FIG. 1.

Referring to FIGS. 1 to 3, S_{tA} and T_{tA} represent the SOC estimation value and the temperature detection value of the battery 11 at the time when the estimate operation of the total remaining time up to the target SOC is executed, that is, at the current time.

The control unit 130 may identify the SOC section (S#m) and the temperature section (T#n) to which the SOC estimation value (S_{tA}) and the temperature detection value (T_{tA}) belong, and obtain the charge rate (C#m_n) associated with the SOC section (S#m) and the temperature section (T#n) from the first charge reference map CRM1. At this time, the control unit 130 may identify the end point of the SOC section (S#m) from the first charge reference map CRM1, and determine the SOC difference (ΔS#m) between the end point of the SOC section (S#m) and the SOC estimation value (S_{tA}). For example, if the SOC estimation value (S_{tA}) is 35%, the SOC estimation value (S_{tA}) belongs to the SOC section (S#4), and the SOC difference (ΔS#4) is 10% - 5% = 5%.

Subsequently, the control unit 130 may determine the predicted charging time value (Δt#m), which represents the remaining time until the SOC of the battery 11 reaches the end point of the SOC section (S#m) from the current time by dividing the capacity corresponding to the SOC difference (ΔS#m) by the charge rate (C#m_n). As an example, it is assumed the maximum capacity of the battery 11 is 1000 mAh, the SOC difference (ΔS#m) is 5%, and the charge rate (C#m_n) is 1.0 C (=1000 mA). Then, the capacity corresponding to the SOC difference (ΔS#m) is 20 mAh, so the predicted charging time value (Δt#m) = 20 mAh/1000 mA = 0.02 hours.

For reference, the maximum capacity of the battery 11 can be estimated using any one of various known methods or a combination of two or more of them. As an example, the control unit 130 may calculate the current maximum capacity of the battery 11 by dividing the accumulated current amount over the period from when the SOC of the battery 11 is at the first value to when the SOC of the battery 11 reaches the second value by the change amount of SOC (i.e., the difference between the first value and the second value). Alternatively, the control unit 130 may determine the maximum capacity of the battery 11 by multiplying the SOH (State Of Health) calculated through any one of various known methods or a combination of two or more of them by a predetermined design capacity (maximum capacity of a new battery).

Next, the control unit 130 inputs the charge rate (C#m_n) and the predicted charging time value (Δt#m) into a pre-given thermal model to determine the predicted temperature change amount (ΔT#m) of the battery 11 until reaching the end point of the SOC section (S#m) from the current point. The thermal model will be described separately later.

The control unit 130 determines the predicted temperature value (T_{tB}) representing the temperature of the battery 11 at the end point of the SOC section (S#m) by adding the predicted temperature change amount (ΔT#m) to the temperature detection value (T_{tA}). As described above, the end point of the SOC section (S#m) coincides with the start point of the SOC section (S#(m+1)), and thus the predicted temperature value (T_{tB}) also represents the temperature of the battery 11 when the SOC of the battery 11 reaches the start point of the SOC section (S#(m+1)) in the future.

The operation of predicting the predicted charging time value for the SOC section (S#(m+1)) is common with the operation of predicting the predicted charging time value for the SOC section (S#m), except that the predicted temperature value (T_{tB}) is used instead of the temperature detection value (T_{tA}) when determining the charge rate in the first charge reference map CRM1.

The control unit 130 repeats the above-described process for each SOC section until the predicted charging time value for the SOC section to which the target SOC belongs is determined, so that the predicted charging time value for each of the current SOC section (S#m) to the last SOC section (S#M) can be determined sequentially. Therefore, if all the predicted charging time values determined for the current SOC section (S#m) to the last SOC section (S#M) are added, the total remaining time until the constant-current charging from the current SOC section to the last SOC section (S#M) is completed can be determined.

From now on, the operation of the thermal model will be described.

The inputs to the thermal model include a charge rate, a battery temperature value, and a predicted charging time value. The battery temperature value input to the thermal model may be a temperature detection value obtained using the battery temperature sensor 115 or the predicted temperature value described above. The output of the thermal model includes the predicted temperature change amount.

The formula below is an example of a temperature change estimate function that can be used as a thermal model. $Δ T = \frac{\left\{\left(α\times {I}^{2}\times R\right)+\frac{{T}_{ATM} - {T}_{BAT}}{β}\right\}}{{C}_{H}} \times Δ t$

In the above formula, T_{BAT} is the battery temperature value, α is the adjustment coefficient (predetermined), I is the charging current value corresponding to the charge rate, R is the internal resistance value of the battery 11, C_{H} is the heat capacity of the battery 11 (predetermined), Δt is the charging time, T_{ATM} is the outdoor air temperature value, and β is the heat exchange coefficient (predetermined). Using the example described above with reference to FIG. 3, when C#m_n (current value corresponding thereto), Δt#m, and T_{tA} are input to I, Δt, and T_{BAT} of the above formula, respectively, ΔT output from the above formula is ΔT#m. For example, if the maximum capacity (buffering capacity) of the battery cell C is 1000 mAh (Ampere-hour), the charge rate of 1.0 C represents that the size of the charging current is 1000 mA.

R and T_{ATM} may be pre-given fixed values, respectively. Alternatively, R may be a variable value that can be adjusted by the control unit 130 according to the charging status of the battery 11. Additionally, the outdoor air temperature detection value obtained using the outdoor air temperature sensor 117 can be used as the T_{ATM} in the above formula.

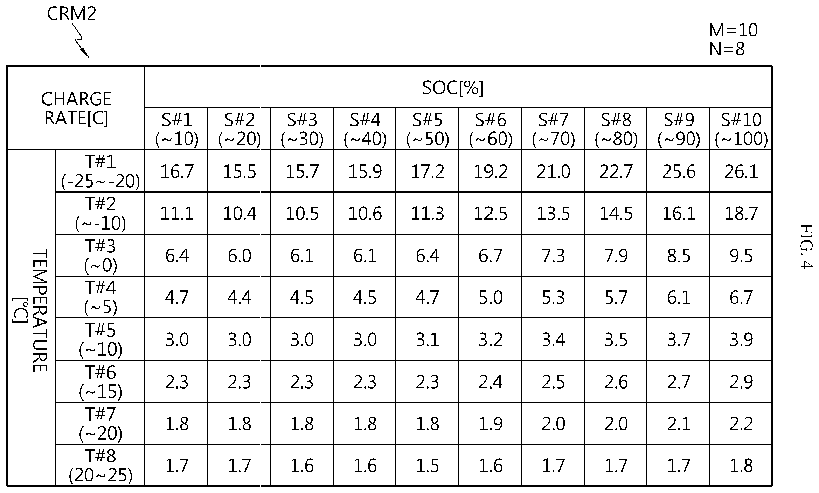

FIG. 4 is a diagram referenced to explain an exemplary second charge reference map used in a charging procedure using a multi-stage constant-current charging protocol. In explaining the second charge reference map CRM2, repeated explanations of common content with the first charge reference map CRM1 will be omitted.

Referring to FIG. 4, the second charge reference map CRM2 is a table or function representing the correspondence of the internal resistance value to the SOC and temperature of the battery 11, and can be referred to as a 'resistance value map'.

In the second charge reference map CRM2, a total of M × N internal resistance values for the first to M^{th} SOC sections (S#1 to S#M) and first to N^{th} temperature sections (T#1 to T#N) are recorded. The symbol R#m_n used in this specification represents the internal resistance value associated with the SOC section (S#m) and the temperature section (T#n).

As with the first charge reference map CRM1, FIG. 4 illustrates the entire SOC range = 0% to 100%, M = 10, N = 8. That is, a total of 80 internal resistance values respectively associated with a pair of a single SOC section and a single temperature section are recorded in the second charge reference map CRM2.

Looking at the second charge reference map CRM2 shown in FIG. 4, it can be seen that in a specific temperature section, as the SOC section is closer to the target SOC (e.g., 100%), the associated internal resistance value tends to gradually increase. For example, in the temperature section (T#1), the internal resistance value (R#_{10_1}) of 26.1 mΩ associated with the SOC section (S#10) is greater than the internal resistance value (R#_{9_1}) of 25.6 mΩ associated with the SOC section (S#9).

Additionally, in a specific SOC section, it can be seen that as the temperature section becomes relatively higher, the associated internal resistance value tends to gradually decrease. As an example, in the SOC section (S#5), the internal resistance value (R#_{5_3}) 6.4 mΩ associated with the temperature section (T#3) is smaller than the internal resistance value (R#_{5_2}) 11.3 mΩ associated with the temperature section (T#2).

Of course, the correspondence between the internal resistance value and the SOC and temperature of the battery 11 depends on the size, weight, active material, appearance, etc. of the battery 11, so FIG. 4 should be understood as a simple example in explaining the present disclosure.

Referring back to the above formula, if R in the above formula is fixed, the actual internal resistance value during charging of the battery 11 cannot be considered at all in predicting the temperature change amount in each temperature section. Therefore, when predicting the predicted charging time value for each SOC section, if the internal resistance value reflecting the temperature is not used, like the conventional method in which the battery temperature value is treated as remaining constant from the current point, sometimes there may be too large error between the predicted value and the actual value of the predicted charging time value. This is a problem that can be fully predicted from the fact that the internal resistance values recorded in the second charge reference map CRM2 differ by several to several tens of times depending on the temperature section even in the same SOC section.

The present disclosure can significantly improve the above-mentioned problems by using the internal resistance value obtained from the second charge reference map CRM2 as an input variable R for the thermal model exemplified above with reference to the formula, in calculating the predicted temperature change amount for each SOC section that must go through a charging procedure using a multi-stage constant-current charging protocol.

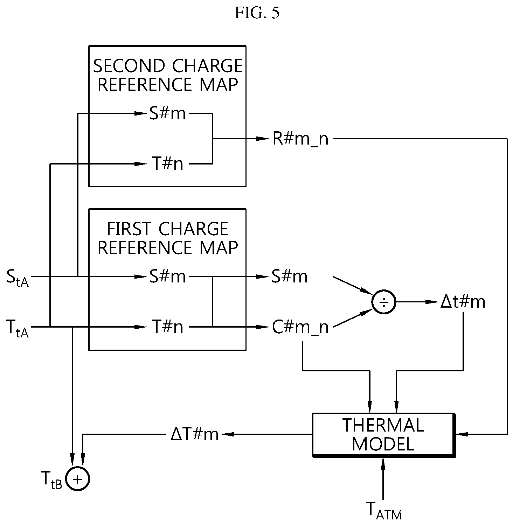

FIG. 5 is a schematic diagram referenced to explain another example of the process of estimating the total remaining time, executed by the battery management system shown in FIG. 1.

The estimating process shown in FIG. 5 is different from the estimating process shown in FIG. 3 in that it additionally utilizes the internal resistance value obtained from the second charge reference map CRM2, so the explanation of contents in common with the estimating process described above with reference to FIG. 3 will be omitted as much as possible, and the explanation will be focused on the differences between the two estimating processes.

Referring to FIG. 5 along with FIGS. 1 to 4, S_{tA} and T_{tA} are the SOC estimation value and the temperature detection value of the battery 11 at the current time, respectively.

The control unit 130 may obtain the charge rate (C#m_n) associated with the SOC section (S#m) and the temperature section (T#n) to which the SOC estimation value (StA) and the temperature detection value (TtA) belong from the first charge reference map CRM1. Additionally, the control unit 130 may obtain the internal resistance value (R#m_n) associated with the SOC section (S#m) and the temperature section (T#n) from the second charge reference map CRM2.

Subsequently, the control unit 130 determines the predicted charging time value (Δt#m), and then determines the predicted temperature change amount (ΔT#m) by additionally inputting the internal resistance value (R#m_n) along with the charge rate (C#m_n) and the predicted charging time value (Δt#m) into the thermal model.

The control unit 130 determines the predicted temperature value (T_{tB}) by adding the predicted temperature change amount (ΔT#m) to the temperature detection value (T_{tA}).

The operation of predicting the predicted charging time value for the SOC section (S#(m+1)) following the current SOC section (S#m) is common with the operation of estimating the predicted charging time value for the SOC section (S#m) described above, except that the predicted temperature value (T_{tB}) at the end point of the SOC section (S#m) is used instead of the temperature detection value (T_{tA}) at the current time, in determining the charge rate in the first charge reference map CRM1.

Meanwhile, in parallel with or as an alternative to the operation of estimating the internal resistance value using the second charge reference map CRM2, the current outdoor air temperature detection value at the current time obtained using the outdoor air temperature sensor 117 can be input as the T_{ATM} of the thermal model.

Unlike the battery temperature, the outdoor air temperature usually does not change significantly during charging of the battery 11. Therefore, whenever the predicted temperature change amount for each SOC section where the charging procedure will proceed after the current time is determined, the outdoor air temperature value detected by the outdoor air temperature sensor 117 at the charging start point (or, the current time) can be identically input into the thermal model repeatedly.

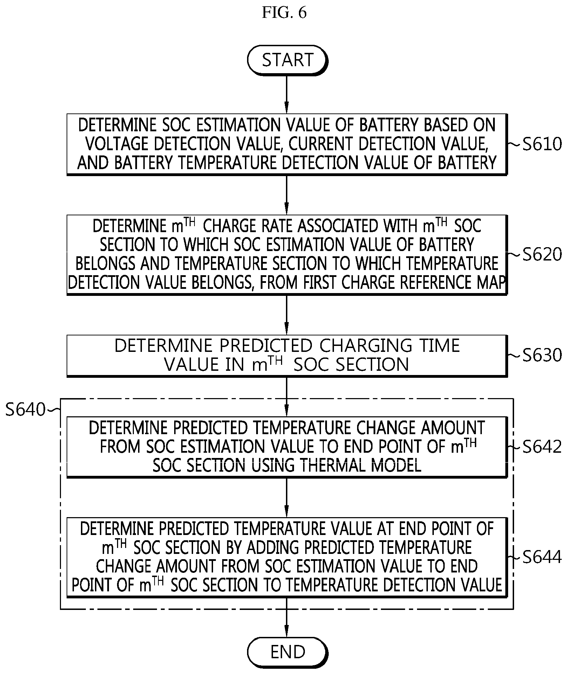

FIG. 6 is a flowchart exemplarily illustrating a battery charging time prediction method according to the first embodiment of the present disclosure. The method of FIG. 6 may be executed by the battery management system 100 at each set time while charging the battery 11 using a multi-stage constant-current charging protocol. In the method of FIG. 6, only the first charge reference map CRM1 is used among the first charge reference map CRM1 and the second charge reference map CRM2.

Referring to FIGS. 1 to 4 and 6, in step S610, the control unit 130 determines the SOC estimation value of the battery 11 based on the voltage detection value, the current detection value, and the battery temperature detection value of the battery 11. The control unit 130 records the voltage detection value, the current detection value, the temperature detection value, and the SOC estimation value determined at each set time in the memory 140. In step S610, the outdoor air temperature detection value (T_{ATM}) can be additionally determined.

In step S620, the control unit 130 determines the m^{th} charge rate (C#m_n) associated with the m^{th} SOC section (S#m, m is a natural number less than or equal to M) to which the SOC estimation value of the battery 11 belongs and the temperature section (T#n) to which the temperature detection value belongs, from the first charge reference map CRM1 associated with the multi-stage constant-current charging protocol. The m^{th} SOC section (S#m) may be the current SOC section, and the m^{th} charge rate may represent the size of the charging current used for constant-current charging in the m^{th} SOC section (S#m).

In step S630, the control unit 130 determines the predicted charging time value in the m^{th} SOC section (S#m) based on the m^{th} charge rate (C#m_n) and the SOC difference (ΔS#m) between the SOC estimation value and the end point of the m^{th} SOC section (S#m).

In step S640, the control unit 130 determines the predicted temperature value at the end point of the m^{th} SOC section (S#m), based on the m^{th} charge rate (C#m_n) and the m^{th} predicted charging time value in the m^{th} SOC section (S#m). If the outdoor air temperature detection value (T_{ATM}) is determined in step S610, the predicted temperature value at the end point of the m^{th} SOC section (S#m) may be determined further based on the outdoor air temperature detection value (T_{ATM}) in step S640.

The above-described step S640 can be executed on the condition that m is less than M. If m is less than M, it means that there remains at least one SOC section following the m^{th} SOC section (S#m) in which the charging procedure is currently in progress. That is, if the m^{th} SOC section (S#m) is not the M^{th} SOC section (S#M), step S640 may be performed.

Step S640 may include step S642 and step S644.

In step S642, the control unit 130 determines the predicted temperature change amount (ΔT#m) from the SOC estimation value to the end point of the m^{th} SOC section (S#m), based on the m^{th} charge rate (C#m_n) and the predicted charging time value in the m^{th} SOC section (S#m), using a pre-given thermal model.

In step S644, the control unit 130 determines the predicted temperature value at the end point of the m^{th} SOC section (S#m) by adding the predicted temperature change amount (ΔT#m) from the SOC estimation value to the end point of the m^{th} SOC section (S#m) to the temperature detection value.

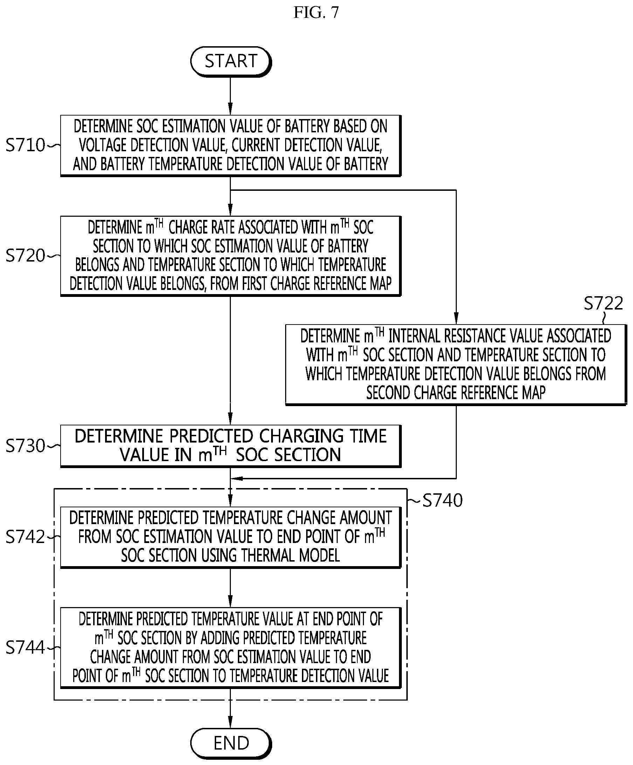

FIG. 7 is a flowchart exemplarily illustrating a battery charging time prediction method according to the second embodiment of the present disclosure. The method of FIG. 7 may be executed by the battery management system 100 at each set time while charging the battery 11 using a multi-stage constant-current charging protocol. In the method of FIG. 7, both the first charge reference map CRM1 and the second charge reference map CRM2 are used.

Referring to FIGS. 1 to 5 and 7, in step S710, the control unit 130 determines the SOC estimation value of the battery 11 based on the voltage detection value, the current detection value, and the battery temperature detection value of the battery 11. Step S710 is substantially the same as step S610.

In step S720, the control unit 130 determines the m^{th} charge rate (C#m_n) associated with the m^{th} SOC section (S#m) to which the SOC estimation value of the battery 11 belongs and the temperature section (T#n) to which the temperature detection value belongs, from the first charge reference map CRM1 associated with the multi-stage constant-current charging protocol. Step S720 is substantially the same as step S620.

In step S722, the control unit 130 determines the m^{th} internal resistance value (R#m_n) associated with the m^{th} SOC section (S#m) and the temperature section (T#n) to which the temperature detection value belongs from the second charge reference map CRM2.

In step S730, the control unit 130 determines the predicted charging time value in the m^{th} SOC section (S#m) based on the m^{th} charge rate (C#m_n) and the SOC difference (ΔS#m) between the SOC estimation value and the end point of the m^{th} SOC section (S#m). Step S730 is substantially the same as step S630.

In step S740, the control unit 130 determines the predicted temperature value at the end point of the m^{th} SOC section (S#m), based on the m^{th} charge rate (C#m_n), the predicted charging time value in the m^{th} SOC section (S#m), and the m^{th} internal resistance value (R#m_n). If the outdoor air temperature detection value (T_{ATM}) is determined in step S710, the predicted temperature value at the end point of the m^{th} SOC section (S#m) can be determined further based on the outdoor air temperature detection value (T_{ATM}) in step S740. Like step S640 described above, step S740 can be executed on the condition that I is less than M.

Step S740 may include step S742 and step S744.

In step S742, the control unit 130 determines the predicted temperature change amount (ΔT#m) from the SOC estimation value to the end point of the m^{th} SOC section (S#m) using a pre-given thermal model, based on the m^{th} charge rate (C#m_n), the predicted charging time value in the m^{th} SOC section (S#m), and the m^{th} internal resistance value (R#m_n).

In step S744, the control unit 130 determines the predicted temperature value at the end point of the m^{th} SOC section (S#m) by adding the predicted temperature change amount (ΔT#m) from the SOC estimation value to the end point of the m^{th} SOC section (S#m) to the temperature detection value.

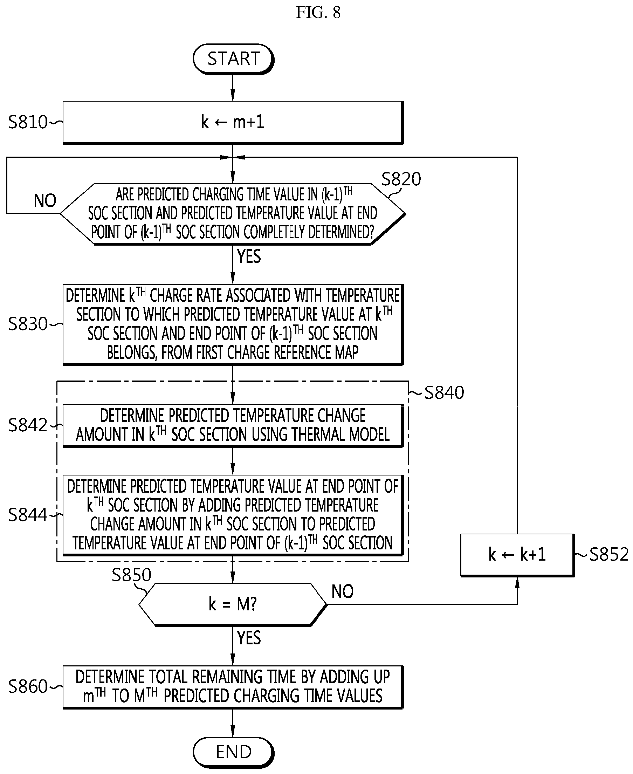

FIG. 8 is a flowchart exemplarily illustrating a battery charging time prediction method according to the third embodiment of the present disclosure. The method of FIG. 8 may be performed subsequent to the method of FIG. 6 or the method of FIG. 7, provided that m is less than M. In the method of FIG. 8, only the first charge reference map CRM1 is used among the first charge reference map CRM1 and the second charge reference map CRM2.

Referring to FIGS. 1 to 8, in step S810, the control unit 130 sets the section index k equal to (m+1).

In step S820, the control unit 130 judges whether the predicted charging time value in the (k-1)^{th} SOC section (S#(k-1)) and the predicted temperature value at the end point of the (k-1)^{th} SOC section (S#(k-1)) are completely determined. If the value of step S820 is "Yes," the process proceeds to step S830.

In step S830, the control unit 130 determines the k^{th} charge rate associated with the k^{th} SOC section (S#k) and the temperature section to which the predicted temperature value at the end point of the (k-1)^{th} SOC section (S#(k-1)) belongs, from the first charge reference map CRM1.

In step S840, the control unit 130 determines the predicted charging time value in the k^{th} SOC section (S#k) and the predicted temperature value at the end point of the k^{th} SOC section (S#k) based on the k^{th} charge rate and the size of the k^{th} SOC section (S#k).

Step S840 may include step S842 and step S844.

In step S842, the control unit 130 determines the predicted temperature change amount in the k^{th} SOC section (S#k) using a pre-given thermal model, based on the k^{th} charge rate and the predicted charging time value in the k^{th} SOC section (S#k).

In step S844, the control unit 130 determines the predicted temperature value at the end point of the k^{th} SOC section (S#k) by adding the predicted temperature change amount in the k^{th} SOC section (S#k) to the predicted temperature value at the end point of the (k-1)^{th} SOC section (S#(k-1)).

In step S850, the control unit 130 judges whether the section index k is equal to M. M can be said to be the identification number of the last SOC section (S#M) to which the target SOC belongs. The fact that the section index k is equal to M means that the determination of the predicted charging time value for the last SOC section (S#M) is completed. If the value of step S850 is "No", the process proceeds to step S852 to increase the section index k by 1, and then the process returns to step S820. That is, the above-described steps S820 to S852 can be repeated from when k is (m+1) until it increases to M.

If the value of step S850 is "Yes," the process proceeds to step S860.

In step S860, the control unit 130 determines the total remaining time until the charging procedure using the multi-stage constant-current charging protocol is terminated (i.e., until the SOC of the battery reaches the target SOC) by adding the m^{th} to M^{th} predicted charging time values. The m^{th} to M^{th} predicted charging time values correspond one-to-one to the m^{th} to M^{th} SOC sections (S#m to S#M).

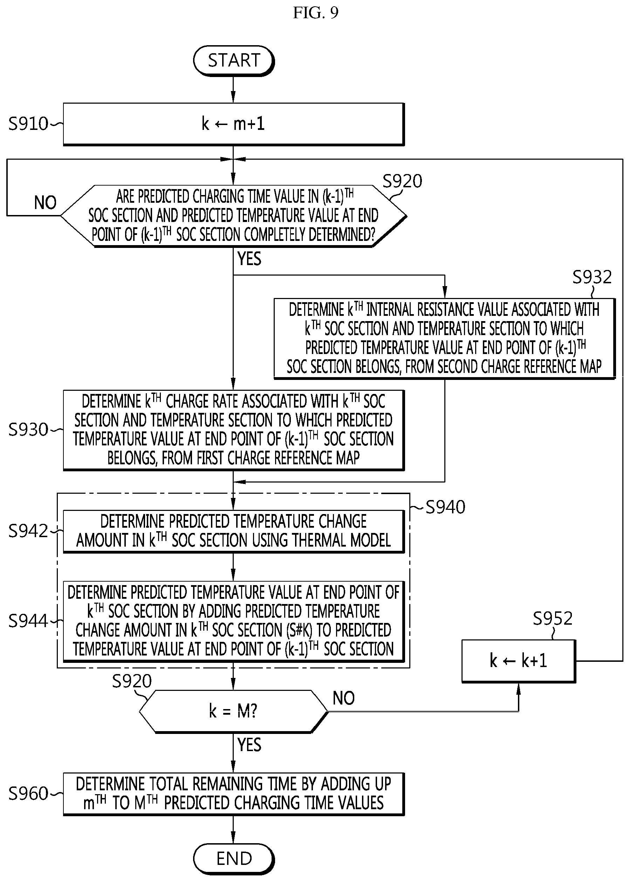

FIG. 9 is a flowchart exemplarily illustrating a battery charging time prediction method according to the fourth embodiment of the present disclosure. The method of FIG. 9 can be performed subsequent to the method of FIG. 6 or the method of FIG. 7, provided that m, which is the section index of the SOC section (S#m) in which the charging procedure is currently in progress, is less than M. In the method of FIG. 9, both the first charge reference map CRM1 and the second charge reference map CRM2 are used.

Referring to FIGS. 1 to 7 and 9, in step S910, the control unit 130 sets the section index k equal to (m+1). Step S910 is substantially the same as step S810.

In step S920, the control unit 130 judges whether the predicted charging time value in the (k-1)^{th} SOC section (S#(k-1)) and the predicted temperature value at the end point of the (k-1)^{th} SOC section (S#(k-1)) are completely determined. Step S920 is substantially the same as step S820.

In step S930, the control unit 130 determines the k^{th} charge rate associated with the k^{th} SOC section (S#k) and the temperature section to which the predicted temperature value at the end point of the (k-1)^{th} SOC section (S#(k-1)) belongs, from the first charge reference map CRM1. Step S930 is substantially the same as step S830.

In step S932, the control unit 130 determines the k^{th} internal resistance value associated with the k^{th} SOC section (S#k) and the temperature section to which the predicted temperature value at the end point of the (k-1)^{th} SOC section (S#(k-1)) belongs, from the second charge reference map CRM2.

In step S940, the control unit 130 determines the predicted charging time value in the k^{th} SOC section (S#k) and the predicted temperature value at the end point of the k^{th} SOC section (S#k) based on the k^{th} charge rate, the size of the k^{th} SOC section (S#k), and the k^{th} internal resistance value.

Step S940 may include step S942 and step S944.

In step S942, the control unit 130 determines the predicted temperature change amount in the k^{th} SOC section (S#k) using a pre-given thermal model, based on the k^{th} charge rate, the predicted charging time value in the k^{th} SOC section (S#k), and the k^{th} internal resistance value.

In step S944, the control unit 130 determines the predicted temperature value at the end point of the k^{th} SOC section (S#k) by adding the predicted temperature change amount in the k^{th} SOC section (S#k) to the predicted temperature value at the end point of the (k-1)^{th} SOC section (S#(k-1)).

In step S950, the control unit 130 judges whether the section index k is equal to M. If the value of step S950 is "No", the process proceeds to step S952. If the value of step S950 is "No", the process proceeds to step S952 to increase the section index k by 1, and then the process returns to step S920. If the value of step S950 is "Yes," the process proceeds to step S960. Step S950 and step S952 are substantially the same as step S850 and step S852.

In step S960, the control unit 130 determines the total remaining time until the charging procedure using the multi-stage constant-current charging protocol is terminated by adding the m^{th} to M^{th} predicted charging time values. Step S960 is substantially the same as step S860.

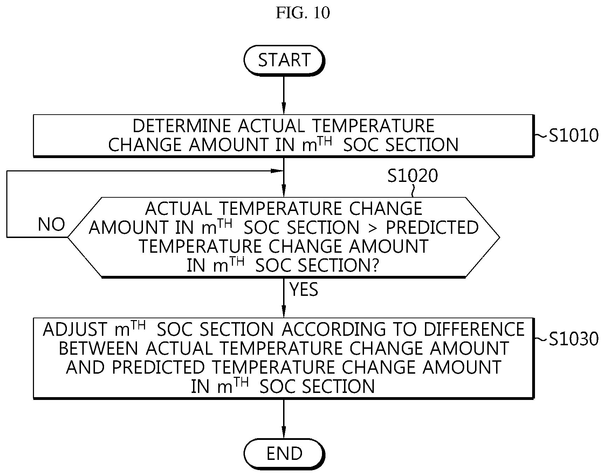

FIG. 10 is a flowchart exemplarily illustrating a battery charging time prediction method according to the fifth embodiment of the present disclosure. The method of FIG. 10 can be executed to adjust the corresponding SOC section, provided that constant-current charging for each SOC section whose predicted charging time value has been determined by any one of the first to fourth embodiments described above with reference to FIGS. 6 to 9 is actually completed.

Referring to FIGS. 1 to 10, in step S1010, the control unit 130 determines the actual temperature change amount in the m^{th} SOC section (S#m). If the m^{th} SOC section (S#m) is a SOC section at the charging start point using the multi-stage constant-current charging protocol, the difference between the battery temperature detection value at the charging start point and the battery temperature detection value at the end point of the m^{th} SOC section (S#m) can be determined as the actual temperature change amount in the m^{th} SOC section (S#m). If the m^{th} SOC section (S#m) is a SOC section that follows the SOC section at the charging start point, the difference between two battery temperature detection values at the start point and the end point of the m^{th} SOC section (S#m) can be determined as the actual temperature change amount in the m^{th} SOC section (S#m).

In step S1020, the control unit 130 determines whether the actual temperature change amount in the m^{th} SOC section (S#m) is greater than the predicted temperature change amount in the m^{th} SOC section (S#m). If the value of step S1020 is "Yes," the process proceeds to step S1030.

In step S1030, the control unit 130 adjusts the m^{th} SOC section (S#m) according to the difference between the actual temperature change amount and the predicted temperature change amount in the m^{th} SOC section (S#m).

As an example, the control unit 130 may reduce the end point of the m^{th} SOC section (S#m) by an adjustment value that has a predetermined positive correlation with respect to the difference. Accordingly, the size of the m^{th} SOC section (S#m) is reduced by the adjustment value. In addition, when m is less than M, the end point of the m^{th} SOC section (S#m) is advanced by the adjustment value, which means that the start point of the (m+1)^{th} SOC section (S#(m+1)) is also advanced by the adjustment value. Therefore, the size of the (m+1)^{th} SOC section (S#(m+1)) is increased by the adjustment value.

In FIG. 10, only the section index m is described, but it can also be commonly applied to the remaining section indexes smaller than or equal to M.

According to the fifth embodiment described above with reference to FIG. 10, the charging procedure for the SOC section in which an unexpected temperature rise occurs is terminated early, while the charging procedure for the SOC section following the corresponding SOC section is started early. As can be seen in the first charge reference map CRM1 described above with reference to FIG. 3, if it is written so that a relatively small charge rate tends to be associated with a relatively high SOC section, the charge rate that causes an excessive temperature rise can be early switched to another lower charge rate, so that the charging procedure using the multi-stage constant-current charging protocol can be safely continued. As a result, there is a technical effect in that the first charge reference map CRM1 is corrected to prevent the battery 11 from being overheated due to charging.

Additionally, the control unit 130 may also correct the second charge reference map CRM2 to correspond to the correction of the first charge reference map CRM1. For example, when a specific SOC section of the first charge reference map CRM1 is adjusted, the specific SOC section of the second charge reference map CRM2 may also be adjusted in the same way.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the claims will become apparent to those skilled in the art from this detailed description.

## Claims

1. A battery management system (100), comprising:
a memory (140) configured to store a first charge reference map (CRM1) in which a total of M × N charge rates for first to M^{th} SOC sections (S#1 to S#M) and first to N^{th} temperature sections (T#1 to T#N) associated with a multi-stage constant-current charging protocol are recorded, wherein M is a natural number greater than or equal to 2, and N is a natural number greater than or equal to 2;
a sensing unit (111, 113, 115, 117) configured to detect voltage, current, temperature of a battery (11) and an outdoor air temperature; and
a control unit (130) configured to determine a SOC estimation value of the battery (11) based on a voltage detection value, a current detection value, and a temperature detection value at a predetermined time interval from a start point of a charging procedure for the battery (11),
wherein the control unit (130) is configured to:
from the first charge reference map (CRM1), determine a m^{th} charge rate associated with a m^{th} SOC section to which the SOC estimation value belongs and a temperature section to which the temperature detection value belongs, wherein m is a natural number less than or equal to M,
determine a predicted charging time value in the m^{th} SOC section, based on the m^{th} charge rate and a SOC difference between the SOC estimation value and an end point of the m^{th} SOC section, and
when m is less than M, further determine a predicted temperature value at the end point of the m^{th} SOC section,
wherein the predicted temperature value at the end point of the m^{th} SOC section represents the temperature of the battery (11) at a start point of a (m+1)^{th} SOC section;
wherein the memory (140) is configured to further store a second charge reference map (CRM2) in which a total of M × N internal resistance values for the first to M^{th} SOC sections (S#1 to S#M) and the first to N^{th} temperature sections (T#1 to T#N) are recorded, and
wherein the control unit (130) is configured to:
from the second charge reference map (CRM2), determine a m^{th} internal resistance value associated with the m^{th} SOC section and the temperature section to which the temperature detection value belongs,
determine a predicted temperature change amount from the SOC estimation value to the end point of the m^{th} SOC section, based on the m^{th} charge rate, the predicted charging time value in the m^{th} SOC section, the m^{th} internal resistance value and the outdoor air temperature, using a pre-given thermal model, and
determine a predicted temperature value at the end point of the m^{th} SOC section by adding the predicted temperature change amount from the SOC estimation value to the end point of the m^{th} SOC section to the temperature detection value.

2. The battery management system according to claim 1, wherein when the charging procedure for the m^{th} SOC section is completed, the control unit (130) is configured to adjust the m^{th} SOC section by comparing the predicted temperature change amount from the SOC estimation value to the end point of the m^{th} SOC section with an actual temperature change amount.

3. The battery management system according to claim 1, wherein, when k is a natural number greater than or equal to (m+1) and less than or equal to M, in the case in which the predicted charging time value in a (k-1)^{th} SOC section and the predicted temperature value at an end point of the (k-1)^{th} SOC section are completely determined, the control unit (130) is configured to:
from the first charge reference map (CRM1), determine a k^{th} charge rate associated with the k^{th} SOC section and the temperature section to which the predicted temperature value at the end point of the (k-1)^{th} SOC section belongs, and
determine a predicted charging time value in the k^{th} SOC section and a predicted temperature value at the end point of the k^{th} SOC section, based on the k^{th} charge rate and a size of the k^{th} SOC section.

4. The battery management system according to claim 3, wherein when the predicted charging time value in the M^{th} SOC section is completely determined, the control unit (130) is configured to determine a total remaining time until the charging procedure using the multi-stage constant-current charging protocol is terminated, by adding the predicted charging time values determined for the m^{th} to M^{th} SOC sections.

5. The battery management system according to claim 3, wherein when the predicted charging time value in the (k-1)^{th} SOC section and the predicted temperature value at the end point of the (k-1)^{th} SOC section are completely determined, the control unit (130) is configured to:
determine a predicted temperature change amount in the k^{th} SOC section, based on the k^{th} charge rate and the predicted charging time value in the k^{th} SOC section, using a pre-given thermal model, and
determine a predicted temperature value at the end point of the k^{th} SOC section by adding the predicted temperature change amount in the k^{th} SOC section to the predicted temperature value at the end point of the (k-1)^{th} SOC section.

6. The battery management system according to claim 3, wherein the memory (140) is configured to further store a second charge reference map (CRM2) in which a total of M × N internal resistance values for the first to M^{th} SOC sections (S#1 to S#M) and the first to N^{th} temperature sections (T#1 to T#N) are recorded, and
wherein the control unit (130) is configured to:
from the second charge reference map (CRM2), determine a k^{th} internal resistance value associated with the k^{th} SOC section and the temperature section to which the predicted temperature value at the end point of the (k-1)^{th} SOC section belongs,
determine a predicted temperature change amount in the k^{th} SOC section, based on the k^{th} charge rate, the k^{th} predicted charging time value, and the k^{th} internal resistance value, and
determine a predicted temperature value at the end point of the k^{th} SOC section by adding the predicted temperature change amount in the k^{th} SOC section to the predicted temperature value at the end point of the k^{th} SOC section and the (k-1)^{th} SOC section.

7. The battery management system according to claim 3, wherein the control unit (130) is configured to adjust the k^{th} SOC section by comparing the predicted temperature change amount in the k^{th} SOC section with an actual temperature change amount, when the charging procedure for the k^{th} SOC section is completed.

8. A battery pack, comprising the battery management system according to any one of claims 1 to 7.

9. An electric vehicle, comprising the battery pack according to claim 8.

10. A battery charging time prediction method, which is performed at a predetermined time interval from a start point of a charging procedure for a battery (11), comprising:
determining (S610) a SOC estimation value of the battery (11) based on a voltage detection value, a current detection value, and a temperature detection value of the battery (11);
determining (S620) a m^{th} charge rate associated with a m^{th} SOC section to which the SOC estimation value belongs and a temperature section to which the temperature detection value belongs, from a first charge reference map (CRM1) in which a total of M × N charge rates for first to M^{th} SOC sections and first to N^{th} temperature sections associated with a multi-stage constant-current charging protocol are recorded, wherein m is a natural number less than or equal to M; and
determining (S630) a predicted charging time value in the m^{th} SOC section, based on the m^{th} charge rate and a SOC difference between the SOC estimation value and an end point of the m^{th} SOC section,
wherein the battery charging time prediction method further comprises determining (S640) a predicted temperature value at the end point of the m^{th} SOC section, when m is less than M, and
wherein the predicted temperature value at the end point of the m^{th} SOC section represents the temperature of the battery at a start point of a (m+1)^{th} SOC section;
wherein the method further comprises, from a second charge reference map (CRM2) in which a total of M × N internal resistance values for the first to M^{th} SOC sections (S#1 to S#M) and the first to N^{th} temperature sections (T#1 to T#N) are recorded,
determining a m^{th} internal resistance value associated with the m^{th} SOC section and the temperature section to which the temperature detection value belongs,
determining a predicted temperature change amount from the SOC estimation value to the end point of the m^{th} SOC section, based on the m^{th} charge rate, the predicted charging time value in the m^{th} SOC section, the m^{th} internal resistance value and an outdoor air temperature, using a pre-given thermal model, and
determining a predicted temperature value at the end point of the m^{th} SOC section by adding the predicted temperature change amount from the SOC estimation value to the end point of the m^{th} SOC section to the temperature detection value.

11. The battery charging time prediction method according to claim 10, further comprising, when k is a natural number greater than or equal to (m+1) and less than or equal to M:
in the case in which the predicted charging time value in a (k-1)^{th} SOC section and the predicted temperature value at an end point of the (k-1)^{th} SOC section are completely determined, from the first charge reference map (CRM1), determining a k^{th} charge rate associated with a k^{th} SOC section and the temperature section to which the predicted temperature value at the end point of the (k-1)^{th} SOC section belongs, and
determining a predicted charging time value in the k^{th} SOC section and a predicted temperature value at the end point of the k^{th} SOC section, based on the k^{th} charge rate and a size of the k^{th} SOC section.

12. The battery charging time prediction method according to claim 11, further comprising:
when the predicted charging time value in the M^{th} SOC section is completely determined, determining a total remaining time until the charging procedure using the multi-stage constant-current charging protocol is terminated, by adding up the predicted charging time values determined for the m^{th} to M^{th} SOC sections.

## Patentansprüche

1. Batteriemanagementsystem (100), umfassend:
einen Speicher (140), der konfiguriert ist, um eine erste Lade-Referenzkarte (CRM1) zu speichern, in der insgesamt M × N Laderaten für erste bis M-te SOC-Abschnitte (S#1 bis S#M) und erste bis N-te Temperaturabschnitte (T#1 bis T#N), die mit einem mehrstufigen Konstantstrom-Ladeprotokoll assoziiert sind, aufgezeichnet sind, wobei M eine natürliche Zahl größer als oder gleich 2 ist und N eine natürliche Zahl größer als oder gleich 2 ist;
eine Sensoreinheit (111, 113, 115, 117), die konfiguriert ist, um Spannung, Strom, Temperatur einer Batterie (11) und eine Außenlufttemperatur zu erfassen; und
eine Steuereinheit (130), die konfiguriert ist, um einen SOC-Schätzwert der Batterie (11) basierend auf einem Spannungserfassungswert, einem Stromerfassungswert und einem Temperaturerfassungswert in einem vorbestimmten Zeitintervall ab einem Startpunkt eines Ladevorgangs für die Batterie (11) zu bestimmen,
wobei die Steuereinheit (130) für Folgendes konfiguriert ist:
anhand der ersten Lade-Referenzkarte (CRM1), Bestimmen einer m-ten Laderate, die mit einem m-ten SOC-Abschnitt, zu dem der SOC-Schätzwert gehört, und einem Temperaturabschnitt, zu dem der Temperaturerfassungswert gehört, assoziiert ist, wobei m eine natürliche Zahl kleiner als oder gleich M ist,
Bestimmen eines vorhergesagten Ladezeitwerts im m-ten SOC-Abschnitt basierend auf der m-ten Laderate und einer SOC-Differenz zwischen dem SOC-Schätzwert und einem Endpunkt des m-ten SOC-Abschnitts, und
wenn m kleiner als M ist, ferner Bestimmen eines vorhergesagten Temperaturwerts am Endpunkt des m-ten SOC-Abschnitts,
wobei der vorhergesagte Temperaturwert am Endpunkt des m-ten SOC-Abschnitts die Temperatur der Batterie (11) an einem Startpunkt eines (m+1)-ten SOC-Abschnitts darstellt;
wobei der Speicher (140) konfiguriert ist, um ferner eine zweite Lade-Referenzkarte (CRM2) zu speichern, in der insgesamt M × N Innenwiderstandswerte für die ersten bis M-ten SOC-Abschnitte (S#1 bis S#M) und die ersten bis N-ten Temperaturabschnitte (T#1 bis T#N) aufgezeichnet sind, und
wobei die Steuereinheit (130) für Folgendes konfiguriert ist:
anhand der zweiten Lade-Referenzkarte (CRM2), Bestimmen eines m-ten Innenwiderstandswerts, der mit dem m-ten SOC-Abschnitt und dem Temperaturabschnitt, zu dem der Temperaturerfassungswert gehört, assoziiert ist,
Bestimmen eines vorhergesagten Temperaturänderungsbetrags vom SOC-Schätzwert bis zum Endpunkt des m-ten SOC-Abschnitts basierend auf der m-ten Laderate, dem vorhergesagten Ladezeitwert im m-ten SOC-Abschnitt, dem m-ten Innenwiderstandswert und der Außenlufttemperatur, unter Verwendung eines vorgegebenen thermischen Modells, und
Bestimmen eines vorhergesagten Temperaturwerts am Endpunkt des m-ten SOC-Abschnitts durch Addieren des vorhergesagten Temperaturänderungsbetrags vom SOC-Schätzwert bis zum Endpunkt des m-ten SOC-Abschnitts zum Temperaturerfassungswert.

2. Batteriemanagementsystem nach Anspruch 1, wobei, wenn der Ladevorgang für den m-ten SOC-Abschnitt abgeschlossen ist, die Steuereinheit (130) konfiguriert ist, um den m-ten SOC-Abschnitt durch Vergleichen des vorhergesagten Temperaturänderungsbetrags vom SOC-Schätzwert bis zum Endpunkt des m-ten SOC-Abschnitts mit einem tatsächlichen Temperaturänderungsbetrag anzupassen.

3. Batteriemanagementsystem nach Anspruch 1, wobei, wenn k eine natürliche Zahl größer als oder gleich (m+1) und kleiner als oder gleich M ist, in dem Fall, in dem der vorhergesagte Ladezeitwert in einem (k-1)-ten SOC-Abschnitt und der vorhergesagte Temperaturwert an einem Endpunkt des (k-1)-ten SOC-Abschnitts vollständig bestimmt sind, die Steuereinheit (130) für Folgendes konfiguriert ist:
anhand der ersten Lade-Referenzkarte (CRM1), Bestimmen einer k-ten Laderate, die mit dem k-ten SOC-Abschnitt und dem Temperaturabschnitt, zu dem der vorhergesagte Temperaturwert am Endpunkt des (k-1)-ten SOC-Abschnitts gehört, assoziiert ist, und
Bestimmen eines vorhergesagten Ladezeitwerts im k-ten SOC-Abschnitt und eines vorhergesagten Temperaturwerts am Endpunkt des k-ten SOC-Abschnitts basierend auf der k-ten Laderate und einer Größe des k-ten SOC-Abschnitts.

4. Batteriemanagementsystem nach Anspruch 3, wobei, wenn der vorhergesagte Ladezeitwert im M-ten SOC-Abschnitt vollständig bestimmt ist, die Steuereinheit (130) konfiguriert ist, um eine verbleibende Gesamtzeit bis zur Beendigung des Ladevorgangs unter Verwendung des mehrstufigen Konstantstrom-Ladeprotokolls durch Addieren der vorhergesagten Ladezeitwerte, die für die m-ten bis M-ten SOC-Abschnitte bestimmt wurden, zu bestimmen.

5. Batteriemanagementsystem nach Anspruch 3, wobei, wenn der vorhergesagte Ladezeitwert im (k-1)-ten SOC-Abschnitt und der vorhergesagte Temperaturwert am Endpunkt des (k-1)-ten SOC-Abschnitts vollständig bestimmt sind, die Steuereinheit (130) für Folgendes konfiguriert ist:
Bestimmen eines vorhergesagten Temperaturänderungsbetrags im k-ten SOC-Abschnitt basierend auf der k-ten Laderate und dem vorhergesagten Ladezeitwert im k-ten SOC-Abschnitt, unter Verwendung eines vorgegebenen thermischen Modells, und
Bestimmen eines vorhergesagten Temperaturwerts am Endpunkt des k-ten SOC-Abschnitts durch Addieren des vorhergesagten Temperaturänderungsbetrags im k-ten SOC-Abschnitt zum vorhergesagten Temperaturwert am Endpunkt des (k-1)-ten SOC-Abschnitts.

6. Batteriemanagementsystem nach Anspruch 3, wobei der Speicher (140) konfiguriert ist, um ferner eine zweite Lade-Referenzkarte (CRM2) zu speichern, in der insgesamt M × N Innenwiderstandswerte für die ersten bis M-ten SOC-Abschnitte (S#1 bis S#M) und die ersten bis N-ten Temperaturabschnitte (T#1 bis T#N) aufgezeichnet sind, und
wobei die Steuereinheit (130) für Folgendes konfiguriert ist:
anhand der zweiten Lade-Referenzkarte (CRM2), Bestimmen eines k-ten Innenwiderstandswerts, der mit dem k-ten SOC-Abschnitt und dem Temperaturabschnitt, zu dem der vorhergesagte Temperaturwert am Endpunkt des (k-1)-ten SOC-Abschnitts gehört, assoziiert ist,
Bestimmen eines vorhergesagten Temperaturänderungsbetrags im k-ten SOC-Abschnitt basierend auf der k-ten Laderate, dem k-ten vorhergesagten Ladezeitwert und dem k-ten Innenwiderstandswert, und
Bestimmen eines vorhergesagten Temperaturwerts am Endpunkt des k-ten SOC-Abschnitts durch Addieren des vorhergesagten Temperaturänderungsbetrags im k-ten SOC-Abschnitt zum vorhergesagten Temperaturwert am Endpunkt des k-ten SOC-Abschnitts und des (k-1)-ten SOC-Abschnitts.

7. Batteriemanagementsystem nach Anspruch 3, wobei die Steuereinheit (130) konfiguriert ist, um den k-ten SOC-Abschnitt durch Vergleichen des vorhergesagten Temperaturänderungsbetrags im k-ten SOC-Abschnitt mit einem tatsächlichen Temperaturänderungsbetrag anzupassen, wenn der Ladevorgang für den k-ten SOC-Abschnitt abgeschlossen ist.

8. Batteriepack, umfassend das Batteriemanagementsystem nach einem der Ansprüche 1 bis 7.

9. Elektrofahrzeug, umfassend das Batteriepack nach Anspruch 8.

10. Batterieladezeit-Vorhersageverfahren, das in einem vorbestimmten Zeitintervall ab einem Startpunkt eines Ladevorgangs für eine Batterie (11) durchgeführt wird, umfassend:
Bestimmen (S610) eines SOC-Schätzwerts der Batterie (11) basierend auf einem Spannungserfassungswert, einem Stromerfassungswert und einem Temperaturerfassungswert der Batterie (11);
Bestimmen (S620) einer m-ten Laderate, die mit einem m-ten SOC-Abschnitt, zu dem der SOC-Schätzwert gehört, und einem Temperaturabschnitt, zu dem der Temperaturerfassungswert gehört, assoziiert ist, anhand einer ersten Lade-Referenzkarte (CRM1), in der insgesamt M × N Laderaten für erste bis M-te SOC-Abschnitte und erste bis N-te Temperaturabschnitte, die mit einem mehrstufigen Konstantstrom-Ladeprotokoll assoziiert sind, aufgezeichnet sind, wobei m eine natürliche Zahl kleiner als oder gleich M ist; und
Bestimmen (S630) eines vorhergesagten Ladezeitwerts im m-ten SOC-Abschnitt basierend auf der m-ten Laderate und einer SOC-Differenz zwischen dem SOC-Schätzwert und einem Endpunkt des m-ten SOC-Abschnitts,
wobei das Batterieladezeit-Vorhersageverfahren ferner das Bestimmen (S640) eines vorhergesagten Temperaturwerts am Endpunkt des m-ten SOC-Abschnitts umfasst, wenn m kleiner als M ist, und
wobei der vorhergesagte Temperaturwert am Endpunkt des m-ten SOC-Abschnitts die Temperatur der Batterie an einem Startpunkt eines (m+1)-ten SOC-Abschnitts darstellt;
wobei das Verfahren ferner, anhand einer zweiten Lade-Referenzkarte (CRM2), in der insgesamt M × N Innenwiderstandswerte für die ersten bis M-ten SOC-Abschnitte (S#1 bis S#M) und die ersten bis N-ten Temperaturabschnitte (T#1 bis T#N) aufgezeichnet sind,
das Bestimmen eines m-ten Innenwiderstandswerts, der mit dem m-ten SOC-Abschnitt und dem Temperaturabschnitt, zu dem der Temperaturerfassungswert gehört, assoziiert ist,
das Bestimmen eines vorhergesagten Temperaturänderungsbetrags vom SOC-Schätzwert bis zum Endpunkt des m-ten SOC-Abschnitts basierend auf der m-ten Laderate, dem vorhergesagten Ladezeitwert im m-ten SOC-Abschnitt, dem m-ten Innenwiderstandswert und einer Außenlufttemperatur, unter Verwendung eines vorgegebenen thermischen Modells, und
das Bestimmen eines vorhergesagten Temperaturwerts am Endpunkt des m-ten SOC-Abschnitts durch Addieren des vorhergesagten Temperaturänderungsbetrags vom SOC-Schätzwert bis zum Endpunkt des m-ten SOC-Abschnitts zum Temperaturerfassungswert umfasst.

11. Batterieladezeit-Vorhersageverfahren nach Anspruch 10, ferner umfassend, wenn k eine natürliche Zahl größer als oder gleich (m+1) und kleiner als oder gleich M ist:
in dem Fall, in dem der vorhergesagte Ladezeitwert in einem (k-1)-ten SOC-Abschnitt und der vorhergesagte Temperaturwert an einem Endpunkt des (k-1)-ten SOC-Abschnitts vollständig bestimmt sind, das Bestimmen einer k-ten Laderate, die mit einem k-ten SOC-Abschnitt und dem Temperaturabschnitt, zu dem der vorhergesagte Temperaturwert am Endpunkt des (k-1)-ten SOC-Abschnitts gehört, assoziiert ist, anhand der ersten Lade-Referenzkarte (CRM1), und
das Bestimmen eines vorhergesagten Ladezeitwerts im k-ten SOC-Abschnitt und eines vorhergesagten Temperaturwerts am Endpunkt des k-ten SOC-Abschnitts basierend auf der k-ten Laderate und einer Größe des k-ten SOC-Abschnitts.

12. Batterieladezeit-Vorhersageverfahren nach Anspruch 11, ferner umfassend:
wenn der vorhergesagte Ladezeitwert im M-ten SOC-Abschnitt vollständig bestimmt ist, das Bestimmen einer verbleibenden Gesamtzeit bis zur Beendigung des Ladevorgangs unter Verwendung des mehrstufigen Konstantstrom-Ladeprotokolls durch Aufaddieren der vorhergesagten Ladezeitwerte, die für die m-ten bis M-ten SOC-Abschnitte bestimmt wurden.

## Revendications

1. Un système de gestion de batterie (100), comprenant :
une mémoire (140) configurée pour stocker une première carte de référence de charge (CRM1) dans laquelle un total de M × N taux de charge pour des premières à M^{ièmes} sections de SOC (S#1 à S#M) et des premières à N^{ièmes} sections de température (T#1 à T#N) associées à un protocole de charge à courant constant multi-étages sont enregistrés, dans lequel M est un nombre entier naturel supérieur ou égal à 2, et N est un nombre entier naturel supérieur ou égal à 2 ;
une unité de détection (111, 113, 115, 117) configurée pour détecter une tension, un courant, une température d'une batterie (11) et une température de l'air extérieur ; et
une unité de commande (130) configurée pour déterminer une valeur d'estimation de SOC de la batterie (11) sur la base d'une valeur de détection de tension, d'une valeur de détection de courant et d'une valeur de détection de température à un intervalle de temps prédéterminé à partir d'un point de départ d'une procédure de charge pour la batterie (11),
dans lequel l'unité de commande (130) est configurée pour :
à partir de la première carte de référence de charge (CRM1), déterminer un m^{ième} taux de charge associé à une m^{ième} section de SOC à laquelle la valeur d'estimation de SOC appartient et à une section de température à laquelle la valeur de détection de température appartient, dans lequel m est un nombre entier naturel inférieur ou égal à M,
déterminer une valeur de temps de charge prédite dans la m^{ième} section de SOC, sur la base du m^{ième} taux de charge et d'une différence de SOC entre la valeur d'estimation de SOC et un point final de la m^{ième} section de SOC, et
lorsque m est inférieur à M, déterminer en outre une valeur de température prédite au point final de la m^{ième} section de SOC,
dans lequel la valeur de température prédite au point final de la m^{ième} section de SOC représente la température de la batterie (11) à un point de départ d'une (m+1)^{ième} section de SOC ;
dans lequel la mémoire (140) est configurée pour stocker en outre une seconde carte de référence de charge (CRM2) dans laquelle un total de M × N valeurs de résistance interne pour les premières à M^{ièmes} sections de SOC (S#1 à S#M) et les premières à N^{ièmes} sections de température (T#1 à T#N) sont enregistrées, et
dans lequel l'unité de commande (130) est configurée pour :
à partir de la seconde carte de référence de charge (CRM2), déterminer une m^{ième} valeur de résistance interne associée à la m^{ième} section de SOC et à la section de température à laquelle la valeur de détection de température appartient,
déterminer une quantité de changement de température prédite de la valeur d'estimation de SOC au point final de la m^{ième} section de SOC, sur la base du m^{ième} taux de charge, de la valeur de temps de charge prédite dans la m^{ième} section de SOC, de la m^{ième} valeur de résistance interne et de la température de l'air extérieur, en utilisant un modèle thermique prédéfini, et
déterminer une valeur de température prédite au point final de la m^{ième} section de SOC en ajoutant la quantité de changement de température prédite de la valeur d'estimation de SOC au point final de la m^{ième} section de SOC à la valeur de détection de température.

2. Le système de gestion de batterie selon la revendication 1, dans lequel, lorsque la procédure de charge pour la m^{ième} section de SOC est achevée, l'unité de commande (130) est configurée pour ajuster la m^{ième} section de SOC en comparant la quantité de changement de température prédite de la valeur d'estimation de SOC au point final de la m^{ième} section de SOC avec une quantité de changement de température réelle.

3. Le système de gestion de batterie selon la revendication 1, dans lequel, lorsque k est un nombre entier naturel supérieur ou égal à (m+1) et inférieur ou égal à M, dans le cas où la valeur de temps de charge prédite dans une (k-1)^{ième} section de SOC et la valeur de température prédite à un point final de la (k-1)^{ième} section de SOC sont complètement déterminées, l'unité de commande (130) est configurée pour :
à partir de la première carte de référence de charge (CRM1), déterminer un k^{ième} taux de charge associé à la k^{ième} section de SOC et à la section de température à laquelle la valeur de température prédite au point final de la (k-1)^{ième} section de SOC appartient, et
déterminer une valeur de temps de charge prédite dans la k^{ième} section de SOC et une valeur de température prédite au point final de la k^{ième} section de SOC, sur la base du k^{ième} taux de charge et d'une taille de la k^{ième} section de SOC.

4. Le système de gestion de batterie selon la revendication 3, dans lequel, lorsque la valeur de temps de charge prédite dans la M^{ième} section de SOC est complètement déterminée, l'unité de commande (130) est configurée pour déterminer un temps restant total jusqu'à ce que la procédure de charge utilisant le protocole de charge à courant constant multi-étages soit terminée, en additionnant les valeurs de temps de charge prédites déterminées pour les m^{ièmes} à M^{ièmes} sections de SOC.

5. Le système de gestion de batterie selon la revendication 3, dans lequel, lorsque la valeur de temps de charge prédite dans la (k-1)^{ième} section de SOC et la valeur de température prédite au point final de la (k-1)^{ième} section de SOC sont complètement déterminées, l'unité de commande (130) est configurée pour :
déterminer une quantité de changement de température prédite dans la k^{ième} section de SOC, sur la base du k^{ième} taux de charge et de la valeur de temps de charge prédite dans la k^{ième} section de SOC, en utilisant un modèle thermique prédéfini, et
déterminer une valeur de température prédite au point final de la k^{ième} section de SOC en ajoutant la quantité de changement de température prédite dans la k^{ième} section de SOC à la valeur de température prédite au point final de la (k-1)^{ième} section de SOC.

6. Le système de gestion de batterie selon la revendication 3, dans lequel la mémoire (140) est configurée pour stocker en outre une seconde carte de référence de charge (CRM2) dans laquelle un total de M × N valeurs de résistance interne pour les premières à M^{ièmes} sections de SOC (S#1 à S#M) et les premières à N^{ièmes} sections de température (T#1 à T#N) sont enregistrées, et
dans lequel l'unité de commande (130) est configurée pour :
à partir de la seconde carte de référence de charge (CRM2), déterminer une k^{ième} valeur de résistance interne associée à la k^{ième} section de SOC et à la section de température à laquelle la valeur de température prédite au point final de la (k-1)^{ième} section de SOC appartient,
déterminer une quantité de changement de température prédite dans la k^{ième} section de SOC, sur la base du k^{ième} taux de charge, de la k^{ième} valeur de temps de charge prédite et de la k^{ième} valeur de résistance interne, et
déterminer une valeur de température prédite au point final de la k^{ième} section de SOC en ajoutant la quantité de changement de température prédite dans la k^{ième} section de SOC à la valeur de température prédite au point final de la k^{ième} section de SOC et de la (k-1)^{ième} section de SOC.

7. Le système de gestion de batterie selon la revendication 3, dans lequel l'unité de commande (130) est configurée pour ajuster la k^{ième} section de SOC en comparant la quantité de changement de température prédite dans la k^{ième} section de SOC avec une quantité de changement de température réelle, lorsque la procédure de charge pour la k^{ième} section de SOC est achevée.

8. Un bloc-batterie, comprenant le système de gestion de batterie selon l'une quelconque des revendications 1 à 7.

9. Un véhicule électrique, comprenant le bloc-batterie selon la revendication 8.

10. Un procédé de prédiction du temps de charge de batterie, qui est exécuté à un intervalle de temps prédéterminé à partir d'un point de départ d'une procédure de charge pour une batterie (11), comprenant :
la détermination (S610) d'une valeur d'estimation de SOC de la batterie (11) sur la base d'une valeur de détection de tension, d'une valeur de détection de courant et d'une valeur de détection de température de la batterie (11) ;
la détermination (S620) d'un m^{ième} taux de charge associé à une m^{ième} section de SOC à laquelle la valeur d'estimation de SOC appartient et à une section de température à laquelle la valeur de détection de température appartient, à partir d'une première carte de référence de charge (CRM1) dans laquelle un total de M × N taux de charge pour des premières à M^{ièmes} sections de SOC et des premières à N^{ièmes} sections de température associées à un protocole de charge à courant constant multi-étages sont enregistrés, dans lequel m est un nombre entier naturel inférieur ou égal à M ; et
la détermination (S630) d'une valeur de temps de charge prédite dans la m^{ième} section de SOC, sur la base du m^{ième} taux de charge et d'une différence de SOC entre la valeur d'estimation de SOC et un point final de la m^{ième} section de SOC,
dans lequel le procédé de prédiction du temps de charge de batterie comprend en outre la détermination (S640) d'une valeur de température prédite au point final de la m^{ième} section de SOC, lorsque m est inférieur à M, et
dans lequel la valeur de température prédite au point final de la m^{ième} section de SOC représente la température de la batterie à un point de départ d'une (m+1)^{ième} section de SOC ;
dans lequel le procédé comprend en outre, à partir d'une seconde carte de référence de charge (CRM2) dans laquelle un total de M × N valeurs de résistance interne pour les premières à M^{ièmes} sections de SOC (S#1 à S#M) et les premières à N^{ièmes} sections de température (T#1 à T#N) sont enregistrées,
la détermination d'une m^{ième} valeur de résistance interne associée à la m^{ième} section de SOC et à la section de température à laquelle la valeur de détection de température appartient,
la détermination d'une quantité de changement de température prédite de la valeur d'estimation de SOC au point final de la m^{ième} section de SOC, sur la base du m^{ième} taux de charge, de la valeur de temps de charge prédite dans la m^{ième} section de SOC, de la m^{ième} valeur de résistance interne et d'une température de l'air extérieur, en utilisant un modèle thermique prédéfini, et
la détermination d'une valeur de température prédite au point final de la m^{ième} section de SOC en ajoutant la quantité de changement de température prédite de la valeur d'estimation de SOC au point final de la m^{ième} section de SOC à la valeur de détection de température.

11. Le procédé de prédiction du temps de charge de batterie selon la revendication 10, comprenant en outre, lorsque k est un nombre entier naturel supérieur ou égal à (m+1) et inférieur ou égal à M :
dans le cas où la valeur de temps de charge prédite dans une (k-1)^{ième} section de SOC et la valeur de température prédite à un point final de la (k-1)^{ième} section de SOC sont complètement déterminées, à partir de la première carte de référence de charge (CRM1), la détermination d'un k^{ième} taux de charge associé à une k^{ième} section de SOC et à la section de température à laquelle la valeur de température prédite au point final de la (k-1)^{ième} section de SOC appartient, et
la détermination d'une valeur de temps de charge prédite dans la k^{ième} section de SOC et d'une valeur de température prédite au point final de la k^{ième} section de SOC, sur la base du k^{ième} taux de charge et d'une taille de la k^{ième} section de SOC.

12. Le procédé de prédiction du temps de charge de batterie selon la revendication 11, comprenant en outre :
lorsque la valeur de temps de charge prédite dans la M^{ième} section de SOC est complètement déterminée, la détermination d'un temps restant total jusqu'à ce que la procédure de charge utilisant le protocole de charge à courant constant multi-étages soit terminée, en additionnant les valeurs de temps de charge prédites déterminées pour les m^{ièmes} à M^{ièmes} sections de SOC.
